# FASCICULE DE BREVET EUROPEEN

(11) **EP 3 304 603 B1**
(45) Date de publication et mention de la délivrance du brevet: **29.07.2020**
(21) Numéro de dépôt: 16729322.4
(22) Date de dépôt: 26.05.2016
(51) Int. Cl.: H01L 31/0224, H01L 31/0749

(54) **FABRICATION D'UNE CELLULE PHOTOVOLTAÏQUE EN COUCHES MINCES À CONTACTS MÉTALLIQUES PERFECTIONNÉS**
HERSTELLUNG EINER FOTOVOLTAISCHEN DÜNNSCHICHTZELLE MIT FORTSCHRITTLICHEN METALLKONTAKTEN
FABRICATION OF A THIN-FILM PHOTOVOLTAIC CELL COMPRISING ADVANCED METAL CONTACTS

(30) Priorité: 28.05.2015 FR 1554837
(43) Date de publication de la demande: 11.04.2018
(73) Titulaire: Electricité de France, 75008 Paris (FR); Centre National de la Recherche Scientifique (CNRS), 75016 Paris (FR)
(72) Inventeur: ROUSSET, Jean, 92170 Vanves (FR); TSIN, Fabien, 94300 Vincennes (FR); LINCOT, Daniel, 92160 Antony (FR)
(74) Mandataire: Plasseraud IP
(86) Numéro de dépôt international: PCT/FR2016/051254
(87) Numéro de publication internationale: WO 2016/189258

(56) Documents cités:
- WO-A1-2012/127397
- JP-B1- 5 694 620
- US-A1- 2008 035 489
- US-A1- 2008 128 019
- US-A1- 2011 253 545

## Description

### Domaine de l'invention

La présente invention concerne la fabrication de cellules photovoltaïques en couches minces, notamment pour des panneaux solaires, et plus particulièrement le dépôt de contacts métalliques employés pour de telles cellules.

### Etat de la technique

Dans le cas des cellules à base de silicium, la solution technique la plus utilisée pour la fabrication de contacts est celle de la sérigraphie d'argent. Cette technique permet des cadences importantes et un faible coût de déploiement. En revanche, ses principaux désavantages sont l'utilisation de l'argent (qui est un métal cher) et la difficulté de déposer des contacts fins (avec une épaisseur inférieure à 100 microns) provoquant un ombrage important sur la cellule. Une alternative en développement est le dépôt de contacts en cuivre. Néanmoins, l'utilisation du cuivre, connu comme étant un élément « toxique » pour le silicium, pose certains problèmes nécessitant une couche de contact en nickel jouant le rôle de barrière de diffusion de cuivre, laquelle doit être déposée préalablement. De plus une couche supérieure d'étain est généralement ajoutée afin de protéger le contact en cuivre de son oxydation.

Dans la filière des cellules photovoltaïques en couches minces à base de CIGS (pour l'alliage cuivre-indium-gallium-sélénium à propriétés photovoltaïques), le procédé communément mis en œuvre est celui d'un contact monolithique permettant d'éviter l'ombrage provoqué par l'utilisation d'une grille métallique. La collecte des charges produites sous illumination est alors assurée par leur diffusion latérale dans l'oxyde transparent déposé en surface, ce qui limite l'une des dimensions des cellules à quelques millimètres. Ce procédé restreint donc grandement l'éventail possible des géométries pour les cellules constitutives d'un panneau solaire. Or, sur un module photovoltaïque de grande taille, il est intéressant de pouvoir varier la surface des cellules qui le composent afin d'ajuster le couple courant-tension en sortie de panneau. De plus, l'intégration monolithique nécessite la gravure du métal en face arrière. Cette technique ne peut pas être envisagée sur des couches photovoltaïques produites par des techniques de croissances électrochimiques. En effet, ce type de dépôt atmosphérique nécessite la continuité du contact métallique en face arrière (sans interruption par une gravure) pour pouvoir être appliqué.

Une alternative à l'intégration monolithique est celle de la sérigraphie de contact d'argent telle que développée dans le domaine des cellules à base de silicium, mais avec une contrainte supplémentaire qui est celle de la basse température de réalisation. En effet, la jonction CIGS/CdS (le CdS étant le composé constitutif d'une couche de type n déposée sur la couche de CIGS de type p) ne résiste pas à des recuits de température supérieure à 200°C. Le dépôt de cuivre, notamment par électrolyse, est difficilement applicable à cause de l'acidité des bains qui sont utilisés (et dont le pH est généralement inférieur à 3), car les couches de contacts transparents (à base de ZnO), présents dans de telles cellules, présentent une sensibilité élevée aux pH acides.

US2011/0253545 décrit le dépôt par électrolyse d'une électrode en zinc sur une cellule solaire en matériau II-VI.

La présente invention vient améliorer cette situation.

### Présentation de l'invention

L'invention propose à cet effet un procédé de fabrication d'une cellule photovoltaïque en couches minces, tel que défini par l'objet de la revendication 1, , le procédé comportant une étape de dépôt d'au moins un contact métallique sur une couche transparente conductrice d' un empilement de couches minces que comporte la cellule. En particulier, le contact métallique est réalisé en zinc, la couche transparente est en oxyde de zinc, ladite étape de dépôt est réalisée par électrolyse, et la couche transparente est déposée par électrolyse.

Dans une forme de réalisation dans laquelle l'empilement de couches comporte une couche à propriétés photovoltaïques recouverte par au moins la couche transparente sur laquelle est déposé le contact, le dépôt par électrolyse est préférentiellement photo-assisté par éclairage issu d'une source lumineuse en regard de l'empilement de couches.

Dans une forme de réalisation, l'empilement de couches minces comporte une couche à propriétés photovoltaïques à base de :
- cuivre,
- indium et/ou gallium, et
- sélénium et/ou soufre.
Il s'agit d'un alliage de type I-III-VI₂ de structure chalcopyrite, désigné par le sigle CIGS ci-après.

Dans une forme de réalisation dans laquelle l'empilement comporte au moins une couche d'absorbeur, à propriétés photovoltaïques, et la cellule comporte un motif de contact métallique déposé sur l'empilement,
le procédé peut comporter les étapes :
- déposer un masque électriquement isolant (et transparent dans les longueurs d'onde du visible) sur l'empilement, le masque étant discontinu de sorte que des parties de surface de l'empilement sont laissées libres par le masque, et
- déposer le motif de contact sur les parties de surface libres, par électrolyse,
   - le dépôt du motif de contact étant photo-assisté par une source lumineuse, de sorte que la couche d'absorbeur génère, par effet photovoltaïque, un photo-courant favorisant le dépôt par électrolyse dans les parties de surface libres, et
   - le masque isolant formant une barrière au photo-courant hors des parties libres, empêchant un dépôt de zinc hors des parties libres.

Dans un exemple de réalisation, l'électrolyse est réalisée dans un bain contenant une solution de chlorure de zinc ZnCl₂.

Dans un exemple de réalisation, l'électrolyse est réalisée dans un bain dans lequel peut être plongée une électrode sacrificielle de zinc (afin d'assurer un apport permanent de zinc dans le bain).

Dans un exemple de réalisation, le bain contient en outre un sel de fond de chlorure de potassium.

Dans une forme de réalisation, l'électrolyse est réalisée dans un bain contenant, outre une source de zinc, un agent nivelant de type acide borique.

Avantageusement, le dépôt par électrolyse peut être réalisé à potentiel de réduction constant.

Avantageusement, dans une variante, le dépôt par électrolyse peut être réalisé à densité de courant appliqué constante.

La présente invention vise aussi une cellule photovoltaïque telle que définie par l'objet de la revendication 11, réalisée par le procédé selon l'invention et comportant ainsi un empilement de couches minces et au moins un contact métallique déposé sur une couche transparente conductrice, d'oxyde de zinc, que comporte l'empilement et réalisé en zinc.

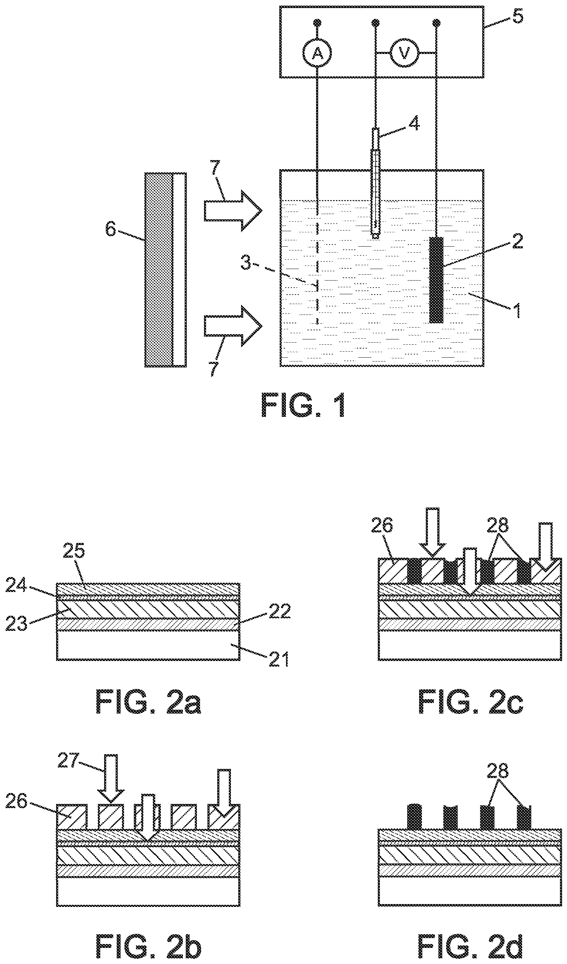

Un exemple d'un tel empilement est présenté plus loin en référence à la figure 2d.

Ainsi, l'invention vient alors résoudre l'ensemble des problèmes qui se posent habituellement dans la filière de cellules solaires à base de silicium (Si) et dans celle de cellules à base de couches minces de CIGS. Elle permet le dépôt de contacts composés d'un matériau à faible coût et sans restriction de géométries (avec notamment des largeurs de contact de l'ordre de 40 micromètres facilement atteignables). Dès lors que le dépôt peut être réalisé par électrolyse, ce procédé est atmosphérique (sans nécessiter de technique de vide) et peut être mis en œuvre à température ambiante. Il présente de plus des vitesses de dépôt très élevées.

Par ailleurs, notamment en termes de performances électriques, un dépôt de zinc offre :
- une résistance de contact la plus faible possible (avantageuse pour la filière Si comme pour la filière CIGS),
- une résistance de « bulk » (matériau plein, lui-même) la plus faible possible grâce à une bonne conductivité du zinc (avantageuse pour la filière Si comme pour la filière CIGS),
- la possibilité de déposer des contacts fins (propriété avantageuse pour la filière Si comme pour la filière CIGS),
- une bonne adhésion mécanique (propriété avantageuse pour la filière Si comme pour la filière CIGS),
- la possibilité d'être déposé à une température ambiante et donc inférieure à 200°C (propriété avantageuse pour la filière CIGS en particulier),
- un procédé de dépôt et un matériau qui sont les moins chers possibles (propriété avantageuse pour la filière Si comme pour la filière CIGS),
- la possibilité de réaliser des motifs complexes adaptables (propriété avantageuse pour la filière CIGS en particulier, qui, pour l'instant, se restreint à un type de contact monolithique).

### Description détaillée

D'autres caractéristiques et avantages de l'invention apparaîtront à l'examen de la description détaillée ci-après, et des dessins annexés sur lesquels :
- la figure 1 illustre schématiquement un exemple de réalisation du procédé selon l'invention ;
- les figures 2a à 2d illustrent des exemples d'étapes de réalisation de contacts métalliques de zinc dans un exemple de réalisation du procédé selon l'invention ;
- la figure 3 illustre la chrono-ampérométrie de l'électrodépôt de zinc sur un empilement à base de CIGS, mettant en évidence le photo-courant généré par la cellule photovoltaïque pendant des phases d'éclairement ;
- la figure 4 illustre des observations au microscope électronique à balayage d'un contact en zinc métallique sur la couche fenêtre d'un empilement à base de CIGS (avec des grossissements progressifs de A) à C)) ;
- la figure 5 illustre des exemples de géométrie de grilles métalliques obtenues par électrodépôt de zinc ;
- la figure 6 compare les caractéristiques courant-tension de deux cellules réalisées dans de mêmes conditions mais comportant, l'une (traits pleins), une grille de zinc électrodéposé au sens de l'invention, et l'autre (traits pointillés) une grille d'alliage Ni/Al évaporé au sens de l'art antérieur.

On se réfère à la figure 1 sur laquelle un bain d'électrolyse 1 contient une solution aqueuse contenant un ou plusieurs cations métalliques pour l'électrodépôt de zinc métallique comme contact en face avant d'une cellule solaire par exemple à base de CIGS dans un mode de réalisation présenté plus loin.

L'élément métallique principal déposé pour le contact est le zinc (Zn°). Il est déposé sur un empilement d'une cellule photovoltaïque en couches minces (dépourvue de contact) portant la référence 2 jouant le rôle « d'électrode de travail ».

Le réacteur d'électrolyse 1 contient une solution de chlorure de zinc (ZnCl₂) comme source de zinc, et possiblement un sel de fond de chlorure de potassium (KCl) et éventuellement un agent nivelant (par exemple de l'acide borique H₃BO₃).

Une contre-électrode 3 est aussi plongée dans le bain. Elle 3 est composée d'un métal noble (Ti, Pt). En variante, elle 3 est de type « électrode sacrificielle », en zinc, pour assurer le renouvellement des ions zinc en solution.

L'électrodépôt est préférentiellement photo-assisté par un éclairage 7 issu d'une source lumineuse 6.

Une électrode 4 au calomel saturé (ECS : +245 mV/ENH) est utilisée comme électrode de référence. Le dépôt peut être réalisé par une technique potentiostatique (potentiel de réduction fixe, appliqué par un générateur de tension/courant 5), ou par une méthode intentiostatique (densité de courant appliqué constante, fixée par le générateur 5). Dans le cas d'un dépôt intentiostatique par exemple, la croissance du contact métallique est seulement contrôlée par le courant appliqué entre le substrat (électrode de travail) et la contre-électrode. L'utilisation d'une électrode de référence n'est alors plus nécessaire, permettant la mise en œuvre d'un procédé extrêmement simple à deux électrodes.

En référence maintenant à la figure 2a, l'empilement de la cellule photovoltaïque est initialement déposé sur un substrat 21 qui peut être une plaque de verre ou une feuille de polymère souple de type polyamide recouverte d'une couche mince métallique, ou un feuillard métallique.

L'empilement de couches minces est lui-même constitué de :
- une couche mince, par exemple de CIGS, formant un absorbeur 23 de type p, déposée sur une couche 22 d'adaptation au substrat (réalisée habituellement en molybdène), le sigle CIGS désignant un alliage chalcopyrite I-III-VI₂, contenant typiquement du cuivre, du gallium et/ou de l'indium, et du sélénium et/ou du soufre,
- une couche tampon 24 de type n, composée de ZnS ou CdS couvrant l'absorbeur CIGS,
- une couche fenêtre 25, composée d'un ou plusieurs des éléments : In, Sn, Zn, O dopé par un ou plusieurs des éléments : B, Al, Ga, F, Cl recouvrant la couche tampon. Il s'agit d'un oxyde transparent conducteur, de type n. Cette couche fenêtre, en oxyde de zinc (ZnO) dans la présente invention, peut par exemple être déposée par pulvérisation cathodique (« magnetron sputtering ») ou selon l'invention par électrolyse.

Il convient d'ajouter ici qu'en variante de la couche 23 de CIGS, précitée, il est possible de prévoir une couche d'absorbeur réalisée en silicium de type p ou n, monocristallin ou poly-cristallin. Dans ce cas, la couche tampon 24 devient une couche d'émetteur, en silicium de type n ou p, respectivement, et couvrant l'absorbeur en silicium type p ou n.

Dans l'exemple de réalisation des figures 2a à 2d, on applique ensuite un masque 26 (figure 2b) sur la surface de la couche fenêtre 25. Il s'agit d'un film électriquement isolant, transparent dans le visible, par exemple un masque plastique réutilisable, un adhésif, une résine texturée par photolithographie ou une couche antireflet texturée par gravure mécanique ou laser.

On applique ensuite un flux lumineux 27 en regard de l'empilement pour initier la croissance du zinc par électrolyse. L'empilement réagit à ce flux lumineux 27 en générant un photo-courant favorisant la croissance de la couche de zinc dans les parties (référence 28 de la figure 2c) laissées libres par le masque 26. Le courant généré sous flux lumineux sur l'ensemble de la surface du substrat par la jonction p/n est consommée par la réaction de réduction des ions de zinc en zinc métallique aux endroits laissés libres par le masque. Ces zones forment un motif de grille adaptée à la surface choisie de la cellule. Par ailleurs, le masque 26 est un isolant électrique et empêche ainsi la réaction de réduction du zinc dans les zones de la surface de l'empilement où le masque est présent.

On obtient alors un motif de contact métallique en zinc 28 de très bonne définition géométrique, après le retrait du masque 26 (figure 2d).

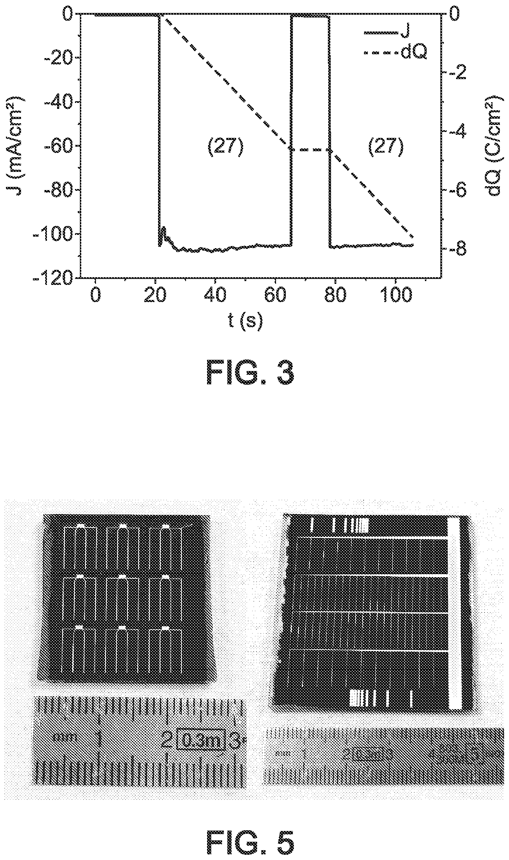

La figure 3 met en évidence l'importance de l'éclairement pour l'électrodépôt sur le type de substrat considéré. Sans éclairement, très peu de courant est enregistré, impliquant peu ou pas de dépôt. Au contraire, sous éclairement (phases (27)), un important courant est enregistré, signifiant que le dépôt est très rapide. Des vitesses typiques de l'ordre de 3 microns/minutes ont pu ainsi être obtenues.

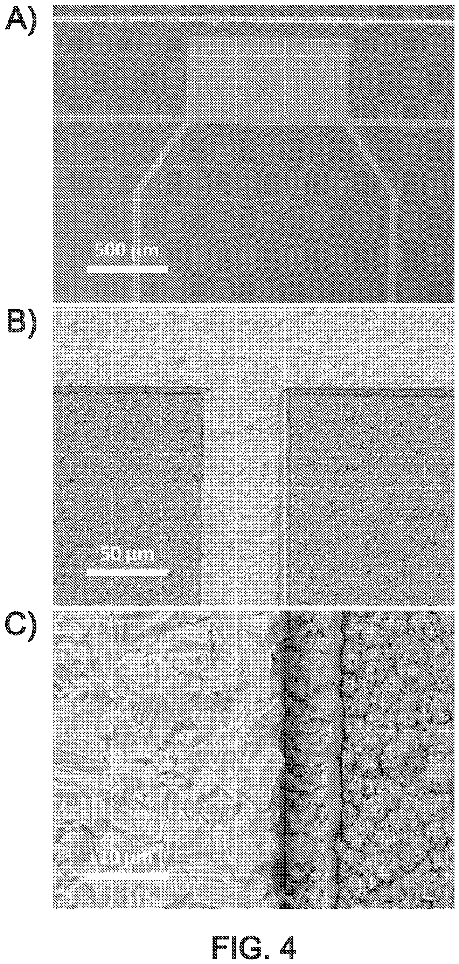

La figure 4 montre la morphologie d'un contact en zinc électrodéposé après retrait du masque. Les observations au microscope électronique à balayage permettent de constater que le dépôt est compact et respecte finement le motif initial, assurant une haute définition des contacts.

La figure 5 montre des exemples de grilles pouvant être déposées par électrodépôt. Le dépôt s'adapte bien à tout type de géométrie.

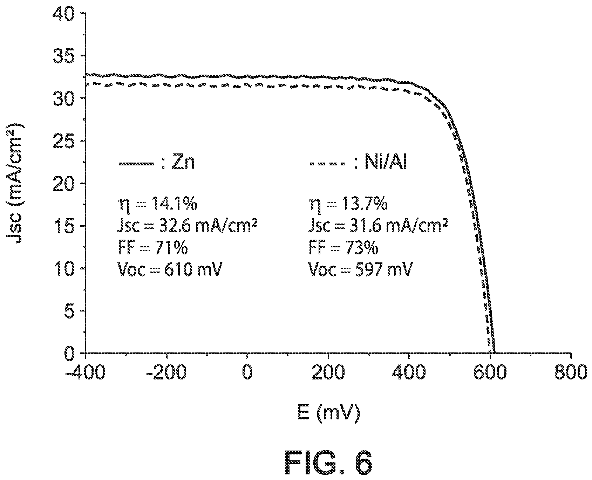

La figure 6 compare les caractéristiques courant-tension d'une cellule solaire avec contact métallique électrodéposé en zinc et évaporé en alliage nickel-aluminium dans le cas d'une cellule solaire à base de CIGS. Les empilements ont été réalisés dans les mêmes conditions (notamment avec du ZnO électrodéposé pour former la couche fenêtre). Le rendement photovoltaïque de la cellule solaire avec contact zinc électrodéposé est meilleur que celui de la cellule avec contact évaporé.

Ainsi, même si des matériaux comme le cuivre ou le nickel peuvent être utilisés pour remplacer l'argent afin d'abaisser les coûts tout en gardant des propriétés électriques comparables, ces matériaux présentent des inconvénients : le cuivre est un élément qui a tendance à diffuser dans les couches en les « empoisonnant », et les poudres de nickel sont fortement toxiques pour les utilisateurs. Les sels de nickel usuellement employés sont ainsi classés comme toxiques et CMR (cancérigène, mutagène, reprotoxique).

Le zinc, lui, est habituellement écarté du fait de ses propriétés électriques théoriques inférieures à celles du cuivre et du nickel. Or, il s'avère en réalité qu'il s'agit d'un candidat présentant de très bonnes performances, notamment pour l'industrie des panneaux solaires. De plus, le zinc est un matériau très abondant et peu coûteux, environ 2,5 fois moins cher que le cuivre par exemple.

L'invention présente alors des avantages listés ci-dessous :
- flexibilité dans le choix de la géométrie des contacts,
- rapidité du procédé,
- simplicité des moyens employés pour l'électrolyse,
- faible coût de mise en œuvre,
- procédé adapté à tout type de cellule solaire (et notamment à base de CIGS).

Par ailleurs, il est possible, notamment pour un empilement à base de CIGS de prévoir un dépôt complet des couches par électrolyse : l'absorbeur, la couche tampon, la couche fenêtre de ZnO, puis les contacts métalliques. La cellule solaire est ainsi réalisée intégralement (à l'exception du substrat verre et de la couche molybdène d'adaptation au substrat) dans des conditions atmosphériques (et avantageusement, par électrolyse).

Bien entendu, la présente invention ne se limite pas aux formes de réalisation décrites ci-avant à titre d'exemples ; elle s'étend à d'autres variantes.

Ainsi, l'application d'un masque intermédiaire a été décrite ci-avant à titre d'exemple de réalisation. Il peut être prévu d'autres techniques, bien entendu, comme par exemple le dépôt d'une couche pleine, suivi d'une gravure. La description de l'exemple de réalisation utilisant un masque a par conséquent la vocation de montrer ici la parfaite morphologie du dépôt et sa finesse, en relation notamment avec les figures 4 et 5.

## Revendications

1. Procédé de fabrication d'une cellule photovoltaïque en couches minces, le procédé comportant une étape de dépôt d'au moins un contact métallique (28) sur une couche transparente conductrice (25) d'un empilement de couches minces que comporte la cellule, **caractérisé en ce que** :
- le contact métallique est réalisé en zinc,
- la couche transparente est en oxyde de zinc,
- ladite étape de dépôt est réalisée par électrolyse,
- et la couche transparente est déposée par électrolyse.

2. Procédé selon la revendication 1, **caractérisé en ce que**, l'empilement de couches comportant une couche à propriétés photovoltaïques recouverte par au moins la couche transparente sur laquelle est déposé le contact, le dépôt par électrolyse est photo-assisté par éclairage issu d'une source lumineuse en regard de l'empilement de couches.

3. Procédé selon l'une des revendications précédentes, **caractérisé en ce que** l'empilement de couches minces comporte une couche à propriétés photovoltaïques à base de :
- cuivre,
- indium et/ou gallium, et
- sélénium et/ou soufre.

4. Procédé selon l'une des revendications précédentes, dans lequel l'empilement comporte au moins une couche d'absorbeur, à propriétés photovoltaïques, et la cellule comporte un motif de contact métallique déposé sur l'empilement,
**caractérisé en ce que** le procédé comporte les étapes :
- déposer un masque électriquement isolant (26) sur l'empilement, le masque étant discontinu de sorte que des parties de surface de l'empilement sont laissées libres par le masque, et
- déposer le motif de contact sur les parties de surface libres, par électrolyse,
• le dépôt du motif de contact étant photo-assisté par une source lumineuse, de sorte que la couche d'absorbeur génère, par effet photovoltaïque, un photo-courant favorisant le dépôt par électrolyse dans les parties de surface libres, et
• le masque isolant formant une barrière au photo-courant hors des parties libres, empêchant un dépôt de zinc hors des parties libres.

5. Procédé selon l'une des revendications précédentes, **caractérisé en ce que** l'électrolyse est réalisée dans un bain contenant une solution de chlorure de zinc ZnCl₂.

6. Procédé selon l'une des revendications précédentes, **caractérisé en ce que** l'électrolyse est réalisée dans un bain dans lequel est plongée une électrode sacrificielle de zinc.

7. Procédé selon l'une des revendications 5 et 6, **caractérisé en ce que** le bain contient en outre un sel de fond de chlorure de potassium.

8. Procédé selon l'une des revendications précédentes, **caractérisé en ce que** l'électrolyse est réalisée dans un bain contenant, outre une source de zinc, un agent nivelant de type acide borique.

9. Procédé selon l'une des revendications précédentes, **caractérisé en ce que** le dépôt par électrolyse est réalisé à potentiel de réduction constant.

10. Procédé selon l'une des revendications 1 à 8, **caractérisé en ce que** le dépôt par électrolyse est réalisé à densité de courant appliqué constante.

11. Cellule photovoltaïque obtenue par la mise en œuvre du procédé selon l'une des revendications précédentes, et comportant un empilement de couches minces et au moins un contact métallique (28) déposé sur une couche transparente conductrice (25), d'oxyde de zinc, que comporte l'empilement, **caractérisée en ce que** le contact métallique est réalisé en zinc.

## Patentansprüche

1. Verfahren zur Herstellung einer Dünnschicht-Photovoltaikzelle, wobei das Verfahren einen Schritt des Abscheidens mindestens eines Metallkontaktes (28) auf einer leitfähigen transparenten Schicht (25) eines Dünnschichtstapels beinhaltet, den die Zelle beinhaltet, **dadurch gekennzeichnet, dass**:
- der Metallkontakt aus Zink ausgeführt ist,
- die transparente Schicht aus Zinkoxid besteht,
- der Schritt des Abscheidens durch Elektrolyse ausgeführt wird,
- und die transparente Schicht durch Elektrolyse abgeschieden wird.

2. Verfahren nach Anspruch 1, **dadurch gekennzeichnet, dass** der Schichtstapel eine Schicht mit photovoltaischen Eigenschaften beinhaltet, die mindestens mit der transparenten Schicht überzogen ist, auf welcher der Kontakt abgeschieden wird, wobei das Abscheiden durch Elektrolyse durch Beleuchten aus einer gegenüber dem Schichtstapel angeordneten Lichtquelle photounterstützt wird.

3. Verfahren nach einem der vorhergehenden Ansprüche, **dadurch gekennzeichnet, dass** der Dünnschichtstapel eine Schicht mit photovoltaischen Eigenschaften beinhaltet auf der Basis von:
- Kupfer,
- Indium und/oder Gallium und
- Selen und/oder Schwefel.

4. Verfahren nach einem der vorhergehenden Ansprüche, bei dem der Stapel mindestens eine Absorberschicht mit photovoltaischen Eigenschaften beinhaltet und die Zelle ein auf dem Stapel abgeschiedenes Metallkontaktmuster beinhaltet,
**dadurch gekennzeichnet, dass** das Verfahren die folgenden Schritte umfasst:
- Abscheiden einer elektrisch isolierenden Maske (26) auf dem Stapel, wobei die Maske diskontinuierlich ist, so dass Flächenbereiche des Stapels von der Maske frei gelassen werden, und
- Abscheiden des Kontaktmusters auf den freien Flächenbereichen durch Elektrolyse,
• wobei das Abscheiden des Kontaktmusters durch eine Lichtquelle photounterstützt wird, so dass die Absorberschicht durch photovoltaischen Effekt einen Photostrom erzeugt, der das Abscheiden durch Elektrolyse in den freien Flächenbereichen begünstigt, und
• wobei die isolierende Maske außerhalb der freien Bereiche eine Barriere für den Photostrom bildet, die ein Abscheiden von Zink außerhalb der freien Bereiche verhindert.

5. Verfahren nach einem der vorhergehenden Ansprüche, **dadurch gekennzeichnet, dass** die Elektrolyse in einem Bad ausgeführt wird, das eine Zinkchloridlösung ZnCl₂ enthält.

6. Verfahren nach einem der vorhergehenden Ansprüche, **dadurch gekennzeichnet, dass** die Elektrolyse in einem Bad ausgeführt wird, in das eine Opferelektrode aus Zink getaucht wird.

7. Verfahren nach einem der Ansprüche 5 und 6, **dadurch gekennzeichnet, dass** das Bad ferner ein Grundsalz aus Kaliumchlorid enthält.

8. Verfahren nach einem der vorhergehenden Ansprüche, **dadurch gekennzeichnet, dass** die Elektrolyse in einem Bad ausgeführt wird, das neben einer Zinkquelle ein Nivelliermittel vom Typ Borsäure enthält.

9. Verfahren nach einem der vorhergehenden Ansprüche, **dadurch gekennzeichnet, dass** das Abscheiden durch Elektrolyse bei konstantem Reduktionspotential ausgeführt wird.

10. Verfahren nach einem der Ansprüche 1 bis 8, **dadurch gekennzeichnet, dass** das Abscheiden durch Elektrolyse bei angelegter konstanter Stromdichte ausgeführt wird.

11. Photovoltaikzelle, die durch die Implementierung des Verfahrens nach einem der vorhergehenden Ansprüche erhalten wird und einen Dünnschichtstapel und mindestens einen Metallkontakt (28) beinhaltet, der auf einer leitfähigen transparenten Schicht (25) aus Zinkoxid abgeschieden ist, die der Stapel beinhaltet, **dadurch gekennzeichnet, dass** der Metallkontakt aus Zink ausgeführt ist.

## Claims

1. Method for the fabrication of a thin-film photovoltaic cell, the method including a deposition step of at least one metal contact (28) on a transparent conductive layer (25) of a stack of thin layers contained in the cell, **characterised in that**:
- the metal contact is made of zinc,
- the transparent layer is made of zinc oxide,
- said deposition step is performed by electrolysis,
- and the transparent layer is deposited by electrolysis.

2. Method according to claim 1, **characterised in that**, the stack of layers including a layer with photovoltaic properties coated with at least the transparent layer whereon the contact is deposited, the deposition by electrolysis is photo-assisted by lighting from a light source facing the stack of layers.

3. Method according to one of the preceding claims, **characterised in that** the stack of thin layers includes a layer with photovoltaic properties based on:
- copper,
- indium and/or gallium, and
- selenium and/or sulphur.

4. Method according to one of the preceding claims, wherein the stack includes at least one absorber layer, with photovoltaic properties, and the cell includes a metal contact pattern deposited on the stack, **characterised in that** the method includes the steps of:
- depositing an electrically insulating mask (26) on the stack, the mask being discontinuous such that surface portions of the stack are left free by the mask, and
- depositing the contact pattern on the free surface portions, by electrolysis,
• the deposition of the contact pattern being photo-assisted by a light source, such that the absorber layer generates, by a photovoltaic effect, a photocurrent promoting the deposition by electrolysis in the free surface portions, and
• the insulating mask forming a barrier to the photocurrent outside the free portions, preventing a deposition of zinc outside the free portions.

5. Method according to one of the preceding claims, **characterised in that** the electrolysis is carried out in a bath containing a zinc chloride ZnCl₂ solution.

6. Method according to one of the preceding claims, **characterised in that** the electrolysis is carried out in a bath wherein a sacrificial zinc electrode is immersed.

7. Method according to one of claims 5 and 6, **characterised in that** the bath further contains a melting salt of potassium chloride.

8. Method according to one of the preceding claims, **characterised in that** the electrolysis is carried out in a bath containing, besides a source of zinc, a boric acid type levelling agent.

9. Method according to one of the preceding claims, **characterised in that** the deposition by electrolysis is carried out at constant reduction potential.

10. Method according to one of claims 1 to 8, **characterised in that** the deposition by electrolysis is carried out at constant applied current density.

11. Photovoltaic cell obtained using the method according to one of the preceding claims, and including a stack of thin layers and at least one metal contact (28) deposited on a transparent conductive layer (25) of zinc oxide, contained in the stack, **characterised in that** the metal contact is made of zinc.
